# EUROPÄISCHE PATENTSCHRIFT

(11) **EP 1 410 052 B1**
(45) Veröffentlichungstag und Bekanntmachung des Hinweises auf die Patenterteilung: **02.08.2006**
(21) Anmeldenummer: 00949107.7
(22) Anmeldetag: 15.06.2000
(51) Int. Cl.: G01R 31/3185

(54) **MULTI-MODE SPEICHERELEMENT**
MULTI-MODE STORAGE CELL
CELLULE DE MEMOIRE MULTIMODE

(30) Priorität: 23.06.1999 DE 19929546
(43) Veröffentlichungstag der Anmeldung: 21.04.2004
(73) Patentinhaber: Infineon Technologies AG, 81669 München (DE)
(72) Erfinder: SINGH, Adit, Auburn, AL 36830 (US); GÖSSEL, Michael, D-15831 Mahlow (DE); SOGOMONYAN, Egor, D-14469 Potsdam (DE)
(74) Vertreter: Reinhard - Skuhra - Weise & Partner
(86) Internationale Anmeldenummer: PCT/DE2000/001961
(87) Internationale Veröffentlichungsnummer: WO 2001/001162

(56) Entgegenhaltungen:
- EP-A- 0 370 194
- GB-A- 2 218 816
- US-A- 5 570 375
- US-A- 5 574 733

## Beschreibung

Die Erfindung betrifft das Gebiet des Testens und des Selbsttestens digitaler sequentieller Schaltungen und die Kombination verschiedener Test- und Funktionsmodes und dient der Verbesserung der Testbarkeit, und insbesondere ein Multi-Mode Speicherelement gemäß dem jeweiligen Oberbegriff der Ansprüche 1 und 2, wie aus der US 5574733 A bekannt.

Durch den hohen Integrationsgrad elektronischer Schaltungen erfordert der Test und der Selbsttest derartiger Schaltungen einen hohen Aufwand. Das betrifft insbesondere den Test sequentieller Schaltungen.

Zur Vereinfachung des Testes sequentieller Schaltungen wurde zunächst das Scan-Element eingeführt, wie es beispielsweise in Eichelberger, E. B. and Williams, T. W., "A Logic Design Structure for LSI Testing", Proc. 14th Design Automation Conference, 1977, New Orleans, pp. 462 - 468, USPS 3783254, USPS 4293919, USPS 4495629 und USPS 5598120 beschrieben ist.

Die Speicherelemente der zu testenden Schaltung lassen sich im Scan-Mode zu einer Schiebekette konfigurieren. Der Testvektor wird in N Takten eingeschoben, wobei N die Länge der Schiebekette ist. Während des Ein- und Ausschiebens ist die normale Datenverarbeitung unterbrochen. Dann wird die zu testende Schaltung in den Funktionsmode umgeschaltet und der eingeschobene Testvektor wird von dem kombinatorischen Teil der Schaltung verarbeitet. Das Ergebnis wird in den Speicherelementen gespeichert und in den darauffolgenden N Takten ausgeschoben, während gleichzeitig der nächste Testvektor eingeschoben wird. Ein Speicherelement mit Scan-Mode läßt sich beispielsweise durch ein Flip-Flop mit vorgeschaltetem Multiplexer, etwa in CMOS, realisieren. Unterschiedliche Implementierungen für Speicherelemente mit Scan-Mode sind beispielsweise in Abramovici, M., Breuer, M. and Friedman. A.. "Digital System Testing and Testable Design", New York, Computer Science Press, 1990, beschrieben.

Nachteil des Testens im Scan-Mode ist, daß durch das Einschieben der Testvektoren viel Zeit verbraucht wird.

Ein weiterer Nachteil besteht beim Testen auf Verzögerungsfehler oder Delay-Fehler. Ein Verzögerungsfehler kann bei einem Zwei-Pattern-Test erkannt werden. Für den Zwei-Pattern-Test sind die Möglichkeiten durch den Scan-Pfad eingeschränkt. Der erste Testvektor kann beliebig eingeschoben werden. Der zweite Testvektor ist aber notwendig ein durch die Schaltung bestimmter Nachfolge-Vektor des eingeschobenen Vektors, was neben dem großen Zeitbedarf beim Einschieben des ersten Testvektors auch die Fehlererkennung begrenzt. Zur Verbesserung der Testbarkeit werden deshalb auch pseudozufällige Selbst-Tests für sequentielle Schaltungen verwendet. Insbesondere werden auch Speicherelemente verwendet, welche in verschiedenen Test-Modes den Scan-Mode und Modes für den Zufallstest aufweisen.

Derartige Speicherelemente sind beispielsweise in Koenemann, B., Mucha, J. and Zwiehoff, G., "Built-in Logic Block Observation Techniques", Proc. Int. Test Conference, 1979, pp. 37 - 41, USPS 4377757, Wang, L. T. and E. J. McClusky, "Concurrent Built-In Logic Block Observer (CILBO)", Int. Symp. on Circuits and Systems, Vol. 3, 1986, pp.1054 - 1057, in Krasniewski, A. and Pilarski, S., "Circular Self-Test-Path: A Low Cost BIST Technique for VLSI Circuits", IEEE Trans. CAD, Vol. 8, 1989, pp. 46 - 55, und in Savir, J., "Scan Latch Design for Delay Test", Proc. Int. Test Conf. 1997, pp. 446 - 453, beschrieben.

Mit der zunehmenden Integration moderner elektronischer Schaltungen und der damit verbundenen Verkleinerung der Breite und Länge der Verbindungslinien zwischen Gattern und Transistoren führen relativ kleine technisch bedingte Abweichungen von den jeweils vorgesehenen Längen und Breiten der Verbindungslinien zu Schwankungen in der Geschwindigkeit der Signalausbreitung, die sich bei den extrem hohen Taktfrequenzen moderner elektronischer Schaltungen als Verzögerungsfehler auswirken können, sodaß mit zunehmendem Integrationsgrad Delay- oder Verzögerungsfehler und damit Delay Tests an Bedeutung zunehmen.

Beim Delay Test ist es wichtig, die tatsächlich im Normalbetrieb aktiven Datenpfade auf Verzögerungsfehler mit der Taktfrequenz der Schaltung im Normalbetrieb, etwa mit einem Zufallstest in einem Selbsttestmode zu testen.

Die bisher bekannten Speicherelemente, die auch Modes für den Zufallstest besitzen, weisen im Testmode für den Zufallstest (Selbsttest) im Datenpfad zusätzliche Verzögerungen auf, die häufig durch ein zusätzliches XOR-Element im Datenpfad bedingt sind, so daß sie für einen tatsächlichen Delay-Test nicht oder nur ungenügend geeignet sind. Um die zusätzlichen Verzögerungen zu verringern, werden auch modifizierte Speicherelemente beschrieben, die die zusätzliche Logik am Eingang des Speicherelementes in das Speicherelement integrieren, wie das beispielsweise in Wang, L. T. and E. J. McClusky, "Concurrent Built-In Logic Block Observer (CILBO)", Int. Symp. on Circuits and Systems, Vol. 3, 1986, pp. 1054 - 1057 dargestellt ist. Damit können aber die Standard Speicherelemente zur Speicherung von einem Bit beim Entwurf nicht verwendet werden.

Teilweise, wie etwa bei dem in Savir, J., "Scan Latch Design for Delay Test", Proc. Int. Test

Conference, 1997, pp. 446 - 453, Latched Icon 2, ist ein sehr großer Hardware- und Verdrahtungsaufwand für die verschiedenen Taktsignale erforderlich.

Teilweise ist bei den vorgeschlagenen Speicherelementen, wie beispielsweise in dem von Krasniewski, A. and Pilarski, S., "Circular Self-Test-Path: A Low Cost BIST Technique for VLSI Circuits, IEEE Trans. CAD, Vol. 8, 1989, pp. 46 - 55, beschriebenen Speicherelement für den zirkularen Selbsttest das Ein- und Ausschieben der Testdaten und der Daten für die Verifikation nicht möglich, was nachteilig ist.

Der Erfindung liegt die Aufgabe zugrunde, ein Multi-Mode Speicherelement mit mindestens zwei verschiedenen Funktionsmodes unter Verwendung von üblichen Speicherelementen zur Speicherung von einem Bit anzugeben, das in einem ersten Mode das Ein- und Aus-scannen oder Ein- und Ausschieben von Testvektoren und Testantworten und in einem weiteren Mode einen pseudo-zufälligen Selbsttest ermöglicht, wobei auf dem Datenpfad im pseudo-zufälligen Selbsttest keine zusätzlichen Verzögerungen auftreten.

Erfindungsgemäß wird die Aufgabe durch den Gegenstand des Anspruchs 1 bzw. 2 gelöst.

Vorteilhafte Ausgestaltungen der Erfindung sind in den Unteransprüchen dargestellt.

Durch die Zusammenführung der beiden Steuerleitungen zu einer Steuerleitung ist es möglich, die Zahl der Anschlußleitungen zu reduzieren.

Als eindeutig auflösbare Boolesche Funktion kann sowohl eine Antivalenz- als auch eine Äquivalenzverknüpfung realisiert werden. Als Speicherelemente zur Speicherung von einem Bit können sowohl Flip-Flops als auch Latches dienen.

Nachfolgend soll die Erfindung an Ausführungsbeispielen erläutert werden.

Dabei zeigen
- Fig. 1: ein Blockschaltbild eines erfindungsgemäßen Multi-Mode Speicherelementes mit zwei Steuerleitungen,
- Fig. 2: ein Blockschaltbild eines erfindungsgemäßen Multi-Mode Speicherelementes mit einer Steuerleitung,
- Fig. 3: ein Schaltbild einer ersten Ausgestaltung der gesteuerten Verknüpfungsschaltung des Multi-Mode Speicherelemente,
- Fig. 4: ein Schaltbild einer zweiten Ausgestaltung der gesteuerten Verknüpfungsschaltung des Multi-Mode Speicherelementes,
- Fig. 5: ein Schaltbild einer dritten Ausgestaltung der gesteuerten Verknüpfungsschaltung des Multi-Mode Speicherelementes,
- Fig. 6: ein Blockschaltbild zur Veranschaulichung der Anwendung des erfindungsgemäßen Multi-Mode Speicherelementes bei der Realisierung einer sequentiellen Schaltung,
- Fig. 7: einen Ausschnitt einer sequentiellen Schaltung mit erfindungsgemäßen Multi-Mode Speicherelementen mit einer Steuerleitung zur Erläuterung der Funktionsweise im pseudo-zufälligen Testmode,
- Fig. 8: einen Ausschnitt einer sequentiellen Schaltung mit erfindungsgemäßen Multi-Mode Speicherlementen mit einer Steuerleitung zur Erläuterung der Funktionsweise im Scan-Mode und parallelen Funktionsmode.

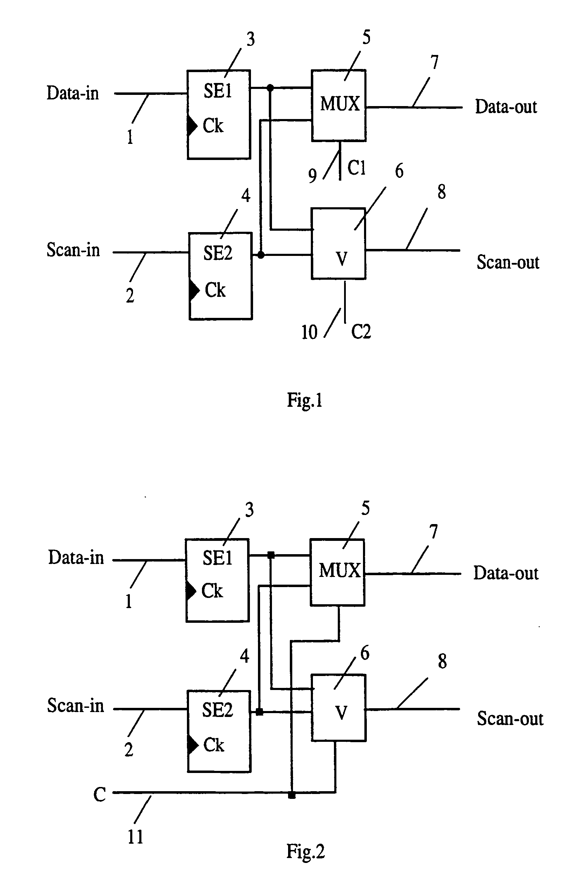

Fig. 1 zeigt ein Blockschaltbild eines erfindungsgemäßen Multi-Mode Speicherelementes mit zwei unterschiedlichen Steuerleitungen.

Der Data-in Eingang 1 ist mit dem Daten-Eingang des ersten Speicherelementes zur Speicherung von einem Bit SE1 3 verbunden. Der Ausgang des Speicherelementes zur Speicherung von einem Bit SE1 3 ist gleichzeitig mit dem ersten Eingang des Multiplexers MUX 5 und mit dem ersten Eingang der gesteuerten Verknüpfunsschaltung V 6 verbunden. Der Scan-in Eingang 2 ist mit dem Daten-Eingang des zweiten Speicherelementes zur Speicherung von einem Bit SE2 4 verbunden. Der Ausgang des zweiten Speicherelementes zur Speicherung von einem Bit SE2 4 ist gleichzeitig mit den jeweils zweiten Eingängen des Multiplexers MUX 5 und der gesteuerten Verknüpfungsschaltung V 6 verbunden.

An der Steuerleitung 9 des Multiplexers MUX 5 liegt das binäre Steuersignal C1 und an der Steuerleitung 10 der gesteuerten Verknüpfungsschaltung V 6 liegt das binäre Steuersignal C2 an.

Der Ausgang des Multiplexers MUX 5 ist mit dem Data-out Ausgang 7 verbunden, während der Ausgang der gesteuerten Verknüpfungsschaltung V 6 mit dem Scan-out Ausgang 8 verbunden ist. Der Takteingang der beiden Speicherelemente zur Speicherung von einem Bit SE1 3 und SE2 4 ist in Figur 1 jeweils mit Ck markiert, die entsprechenden Leitungen für das Taktsignal sind nicht eingezeichnet.

Fig. 2 zeigt ein Blockschaltbild eines erfindungsgemäßen Multi-Mode Speicherelementes mit einer binären Steuerleitung 11, die gleichzeitig sowohl den Multiplexer MUX 5 als auch die Verknüpfungsschaltung V 6 steuert.

Der Unterschied des in Figur 2 gezeigten Multi-Mode Speicherelementes von dem in Figur 1 gezeigten Multi-Mode Speicherelement besteht darin, daß bei dem in Figur 2 gezeigten Multi-Mode Speicherelement der Multiplexer MUX 5 und die gesteuerte Verknüpfungsschaltung V 6, die in Figur 1 mit zwei unterschiedlichen Steuerleitungen 9 und 10 verbunden sind, mit einer gemeinsamen Steuerleitung 11 verbunden sind. Ansonsten stimmen die Speicherelemente von Figur 1 und Figur 2 überein, was auch durch die gleiche Bezeichnung der gleichartigen Funktionseinheiten deutlich wird.

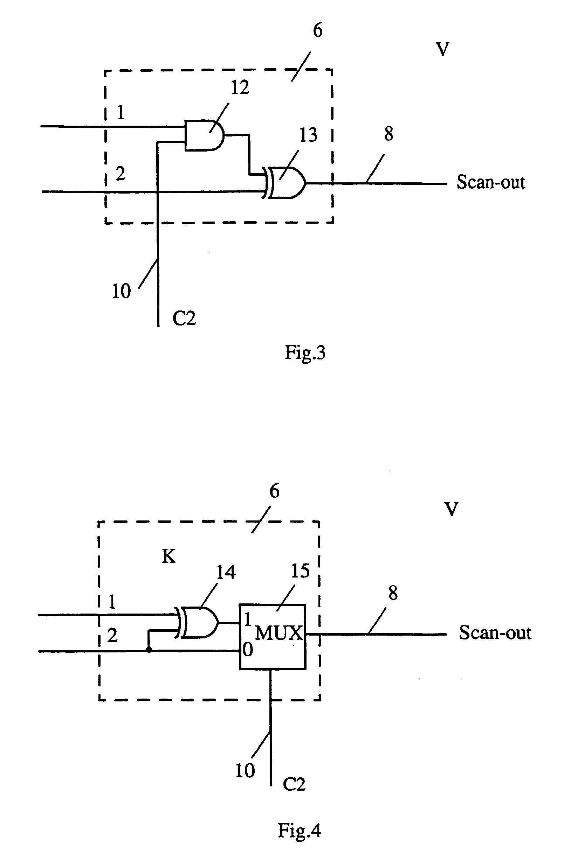

Fig. 3 zeigt eine erste Realisierung der gesteuerten Verknüpfungsschaltung V.

Der erste Eingang der Verknüpfungsschaltung V 6, der mit dem Ausgang des ersten Speicherelementes zur Speicherung von einem Bit SE1 3 in Figur 1 verbunden ist, ist mit dem ersten

Eingang eines UND-Gatters 12 verbunden, in dessen zweiten Eingang die das Steuersignal C2 tragende Leitung 10 geführt ist. Das Aussgangssignal des UND-Gatters 12 ist in den ersten Eingang eines XOR-Gatters 13 geführt, dessen zweiter Eingang mit dem zweiten Eingang der Verknüpfungsschaltung V 6 verbunden ist, der mit dem Ausgang des Speicherelementes zur Speicherung von einem Bit SE2 4 in Figur 1 verbunden ist. Der Ausgang des XOR-Gatters 13 ist mit dem Scan-out Ausgang 8 des Multi-Mode Speicherelementes in Figur 1 verbunden.

Nimmt das Steuersignal C2 den Wert logisch 1 an, dann werden die Signale an den Eingängen der Verknüpfunsschaltung V 6 durch das XOR-Gatter 13 logisch antivalent verknüpft.

Nimmt das Steuersignal C2 den Wert logisch 0 an, dann wird das Signal, das an dem zweiten

Eingang der Verknüpfungsschaltung V6 anliegt, in dem XOR-Gatter 13 mit dem Wert 0 logisch verknüpft, so daß es unverändert an den Scan-out-Ausgang 8 der Verknüpfungsschaltung 6 weitergeleitet wird.

Fig. 4 zeigt eine zweite Realisierung der gesteuerten Verknüpfungsschaltung V.

Der erste Eingang der Verknüpfungsschaltung V 6, der mit dem Ausgang des ersten Speicherelementes zur Speicherung von einem Bit SE1 3 in Figur 1 verbunden ist, ist mit dem ersten

Eingang eines XOR-Gatters 14 verbunden, dessen Ausgang mit dem 1-Eingang eines Multi-plexers MUX 15 verbunden ist.

Der zweite Eingang der Verknüpfungsschaltung V 6, der mit dem Ausgang des zweiten Speicherelementes zur Speicherung von einem Bit SE2 4 in Figur 1 verbunden ist, ist sowohl mit dem zweiten Eingang des XOR-Gatters 14 als auch mit dem 0-Eingang des Multiplexers MUX 15 verbunden, dessen Ausgang mit dem Scan-out Ausgang 8 der Verknüpfungsschaltung 6 verbunden ist.

Nimmt das Steuersignal C2 den Wert logisch 1 an, dann werden die Signale an den Eingängen der Verknüpfungsschaltung V 6 durch das XOR-Gatter 14 logisch antivalent verknüpft und durch den Mutltiplexer MUX 15 auf den Scan-out Ausgang 8 geleitet.

Nimmt das Steuersignal C2 den Wert logisch 0 an, dann wird das Signal, das an dem zweiten Eingang von V 6 anliegt, direkt über den Multiplexer 15 an den Scan-out Ausgang 8 der Verknüpfungsschaltung 6 geleitet.

Man bemerkt, daß die Schaltungen von Figur 3 und 4 logisch gleichwertig oder äquivalent sind, obwohl sie sich strukturell unterscheiden.

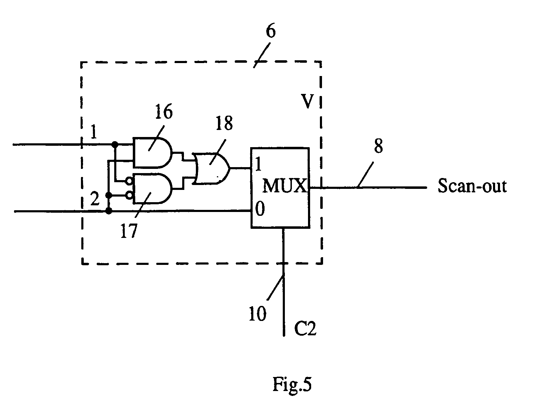

Fig. 5 zeigt eine weitere mögliche Realisierung der gesteuerten Verknüpfungsschaltung V 6.

Der erste Eingang der Verknüpfungsschaltung V 6, der mit dem Ausgang des ersten Speicherelementes zur Speicherung von einem Bit SE1 3 in Figur 1 verbunden ist, ist mit dem ersten Eingang eines UND-Gatters 16 und gleichzeitig in negierter Form mit dem ersten Eingang eines weiteren UND-Gatters 17 verbunden.

Der zweite Eingang der Verknüpfungsschaltung V 6, der mit dem Ausgang des zweiten Speicherelementes zur Speicherung von einem Bit SE2 4 in Figur 1 verbunden ist, ist mit dem zweiten Eingang des UND-Gatters 16, in negierter Form mit dem zweiten Eingang des UND-Gatters 17 und mit dem 0-Eingang des Multiplexers 19 verbunden, dessen Ausgang mit dem Scan-Ausgang 8 der Verknüpfungsschaltung V 6 verbunden ist. Der Ausgang des UND-Gatters 16 ist mit dem ersten Eingang des ODER-Gatters 18 verbunden, dessen Ausgang in den 1-Eingang des Multiplexers 19 geführt ist, dessen Steuereingang mit der das Steuersignal C2 tragenden Steuerleitung 10 der Verknüpfungsschaltung V 6 verbunden ist.

Der Ausgang des UND-Gatters 17 ist mit dem zweiten Eingang des ODER-Gatters 18 verbunden. Man bemerkt, daß für C2 = 1 die Verknüpfungsschaltung V 6 die logische Äquivalenzverknüpfung der auf ihren mit den mit den Ausgängen der beiden Speicherelemente zur Speicherung von einem Bit SE1 3 und SE2 4 verbundenen Eingängen anliegenden Werte bildet und für C2 = 0 ihren zweiten, mit dem Speicherelement zur Speicherung von einem Bit SE2 4 verbundenen Eingang logisch mit ihrem Ausgang verbindet.

Die Äquivalenzverknüpfung ist dabei mit den Bauelementen UND, ODER und NEGATOR realisiert worden.

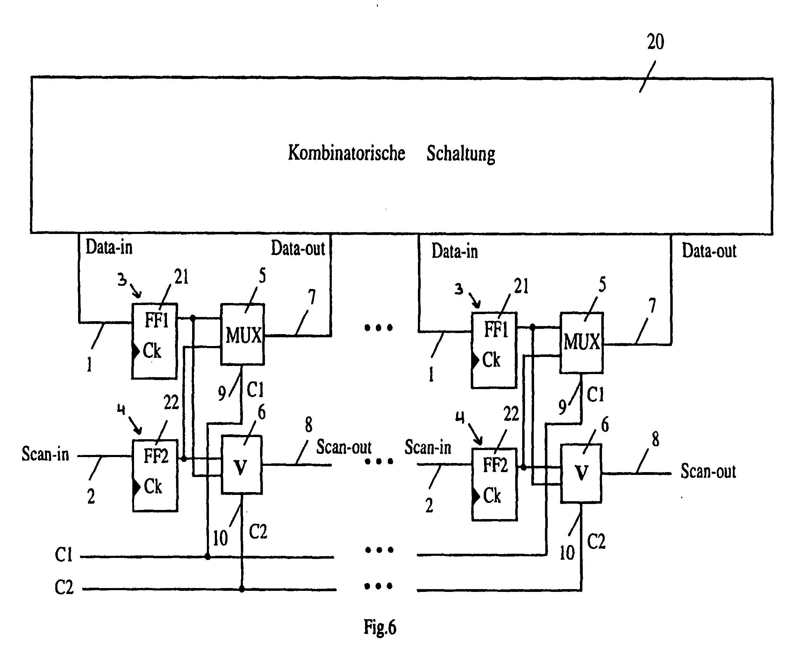

Fig. 6 veranschaulicht, wie die erfindungsgemäßen Multi-Mode Speicherelemente zur Realisierung einer sequentiellen Schaltung angewandt werden können. Dabei sind die Speicherelemente zur Speicherung von einem Bit SE1 3 und SE2 4 in Fig.1 als Flip-Flops FF1 21 und FF2 22 realisiert.

Die erfindungsgemäßen Multi-Mode Speicherelemente sind über ihre Scan-out Ausgänge 8 und ihre Scan-in Eingänge 2 zu einem Scan-Pfad verbunden, wie das im Entwurf sequentieller Schaltungen mit Scan-Pfad üblich ist und beispielsweise in Abramovici, M., Breuer, M. and Friedman, A., "Digital System Testing and Testable Design", New York, Computer Science Press, 1990, beschrieben ist. Die Datenausgänge Data-out 7 der Multi-Mode Speicherelemente sind in die zugehörigen Eingänge der kombinatorischen Schaltung 20 geführt und die entsprechenden Ausgänge der kombinatorischen Schaltung 20 sind mit den Data-in Eingängen 1 der zugehörigen Flip-Flops FF1 21 verbunden.

Sind die Werte der Steuersignale C1 und C2 so gewählt, daß der Ausgang des jeweils ersten Flip-Flops FF1 21 direkt mit dem Data-out Ausgang 7 verbunden ist, und daß der Ausgang des jeweils zweiten Flip-Flops FF2 22 direkt mit dem Scan-out Ausgang 8 verbunden ist, so wird von der Schaltung in Figur 6 eine normale Verarbeitung der Daten in den Flip-Flops FF1 21 und der kombinatorischen Schaltung 20 durchgeführt. Überraschenderweise können dann gleichzeitig zur normalen Funktionsweise der sequentiellen Schaltung, die durch die Flip-Flops FF1 21 und die kombinatorische Schaltung 20 realisiert wird, in die Flip-Flops FF2 22, die eine Kette bilden, Daten eingeschoben und Daten ausgeschoben werden, so daß durch die Flip-Flops FF2 22 gleichzeitig zur normalen Funktionsweise ein Scan-Pfad realisiert wird.

Man sieht unmittelbar, daß sich für verschiedene Werte der Steuersignale C1 und C2 verschiedene Arbeitsweisen oder Modes ergeben, die für einen ausgebildeten Entwerfer unmittelbar verständlich sind, wie zum Beispiel eine normale Verarbeitung der Daten in den Flip-Flops FF1 21 und gleichzeitig eine Addition modulo 2 der Ausgänge der Flip-Flops FF1 21 und FF2 22.

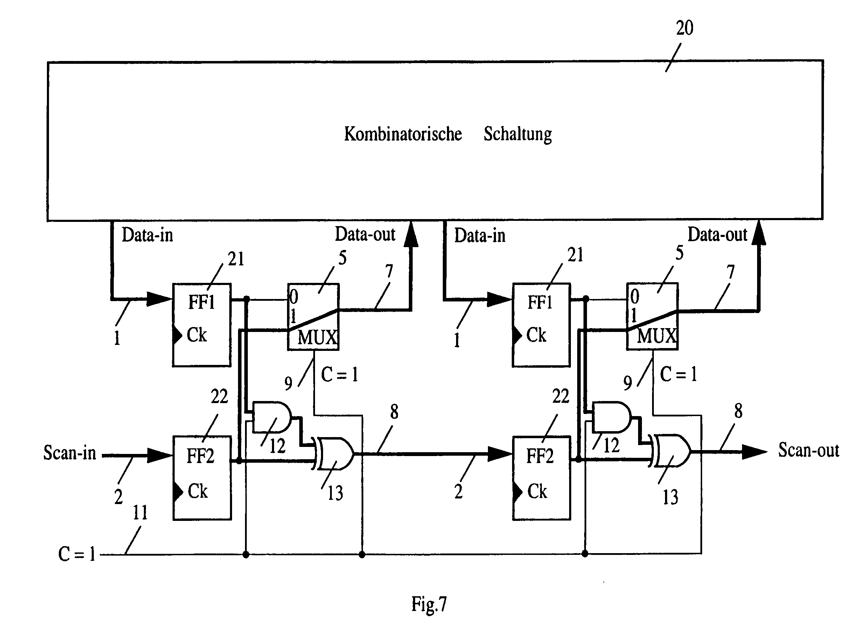

Zur Verdeutlichung der Wirkungsweise des erfindungsgemäßen Speicherelementes im pseudo-zufälligen Test zeigt Figur 7 einen Ausschnitt einer sequentiellen Schaltung in einer speziellen Ausgestaltung der Erfindung. Für die Verknüpfunsschaltung V 6 ist die in Figur 3 dargestellte Realisierung gewählt worden. Wie in Figur 2 dargestellt, wird das erfindungsgemäße Speicherelement von nur einer Steuerleitung 11, die den Wert C führt, gesteuert. Als Speicherelemente zur Speicherung von einem Bit sind wieder Flip-Flops gewählt worden.

Der Ausgang des ersten Flip-Flops FF1 21 ist mit dem 0-Eingang des Multiplexer MUX 5 verbunden, so daß er für den Wert des Steuersignals C = 0 direkt mit dem Data-out Ausgang 7 verbunden ist. Der Ausgang der zweiten Flip-Flops FF2 22 ist mit dem 1-Eingang des Multiplexers MUX 5 verbunden, so daß er für den Wert C = 1 des Steuersignals direkt mit dem Data-out Ausgang 7 verbunden ist. Figur 7 zeigt zwei aufeinanderfolgende, miteinander im Scan-Pfad unmittelbar verbundene Speicherelemente. Für den Wert des Steuersignals ist C = 1 gewählt. Die aktiven Datenpfade sind zum besseren Verständnis fett gezeichnet. Für diesen Wert des Steuersignals soll die Funktionsweise nun noch detaillierter erläutert werden.

Die zum betrachteten diskreten Zeitpunkt t in den zweiten Flip-Flops FF2 22 gespeicherten binären Werte liegen über die jeweiligen Multiplexer MUX 5 an den Eingängen der Kombinatorischen Schaltung 20 an. Sie werden in ihr in einem gewissen Zeitintervall dt verarbeitet und die durch die Kombinatorische Schaltung 20 verarbeiteten Daten werden in den ersten Flip-Flops FF1 21 im nächsten Takt gespeichert, wobei der Wert für dt allein durch die Kombinatorik 20 und den Multiplexer 5 bestimmt ist.

Gleichzeitig wird der Wert, der in jeweils ersten Flip-Flop FF1 21 gespeichert ist, mit dem Wert, der in dem jeweils entsprechenden zweiten Flip-Flop FF2 22 gespeichert ist, in dem jeweiligen XOR-Gatter 13 in einem Zeitintervall dt' antivalent verknüpft und im nächsten Takt in dem im Scan-Pfad darauffolgenden zweiten Flip-Flop FF2 22 gespeichert.

Das Zeitintervall dt' ist durch die Gatterlaufzeiten des UND-Gatters 12 und des XOR-Gatters 13 bestimmt. Man kann davon ausgehen, daß das Zeitintervall dt' kleiner als das Zeitintervall dt ist, da die kombinatorische Schaltung 20 allgemein komplexer als eine Reihenschaltung eines UND-Gatters und eines XOR-Gatters sein wird.

Verbindet man den Scan-out Ausgang 8 des letzten Multi-Mode Speicherelementes im Scan-Pfad mit dem Scan-in Eingang 2 des ersten Multi-Mode Speicherelementes im Scan-Pfad, dann kann man in einfacher Weise einen prinzipiell bekannten pseudo-zufälligen zirkularen Selbsttest durchführen, wie er etwa in Krasniewski, A. and Pilarski, S., "Circular Self-Test Path: A Low Cost BIST Technique for VLSI Circuits", IEEE Trans. CAD, Vol. 8, 1989, pp. 46 - 55, beschrieben ist.

Als wesentlichen Unterschied wird man aber bemerken, daß im Datenpfad während des pseudo-zufälligen Tests, hier vom zweiten Flip-Flop FF2 22 über den Multiplexer 5 und die kombinatorische Schaltung 20 zum ersten Flip-Flop FF1 21 kein zusätzliches XOR-Gatter eingefügt ist, so daß hier, im Unterschied zu bisher bekannten Möglichkeiten, ein pseudo-zufälliger Test der tatsächlichen Verzögerung möglich ist, obwohl ganz übliche Flip-Flops zum Aufbau des erfindungsgemäßen Multi-Mode Speicherelementes verwendet werden.

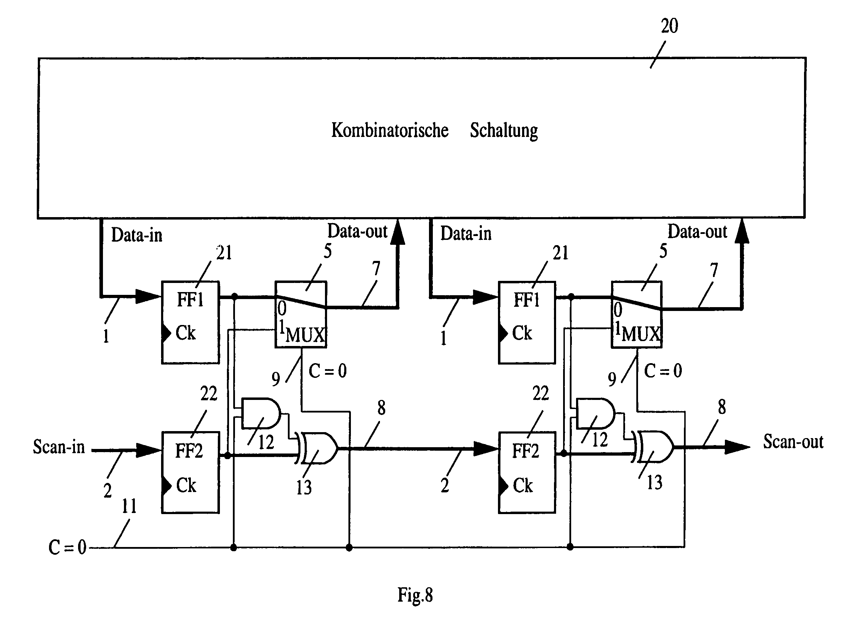

Zur Verdeutlichung der Wirkungsweise des erfindungsgemäßen Multi-Mode Speicherelementes im Scan-Mode und gleichzeitigem normalen Funktionsmode zeigt Fig. 8 den gleichen Ausschnitt einer sequentiellen Schaltung wie in Fig. 7. Im Unterschied zu Fig. 7 ist in Fig. 8 der Wert des Steuersignales C = 0 gewählt worden. Die aktiven Datenpfade sind zum besseren Verständnis wieder fett gezeichnet. Die zum betrachteten diskreten Zeitpunkt t in den Flip-Flops FF1 21 gespeicherten Werte werden im normalen Funktionsmode in der kombinatorischen Schaltung 20 verarbeitet und das Ergebnis wird im nächsten Takt wieder in den Flip-Flops FF1 21 gespeichert. Gleichzeitig werden die in den Flip-Flops FF2 22 gespeicherten Werte in die im Scan-Pfad jeweils benachbarten Flip-Flops FF2 22 geschoben, so daß das Einscannen der Werte in die Flip-Flops FF2 22 parallel zur normalen Funktion der sequentiellen Schaltung erfolgen kann.

Für einen ausgebildeten Entwerfer ist es klar, daß er als Speicherlemente zur Speicherung von einem Bit anstelle von Flip-Flops auch Latches verwenden kann.

Für einen ausgebildeten Entwerfer liegt es nahe, die erfindungsgemäße Schaltung des Multi-Mode Speicherlementes leicht zu modifizieren und an die verwendete Technologie anzupassen, wie das für jeden Schaltungsentwurf üblich ist.

So wird er die Bauelemente in einer bestimmten Bauelementebasis und Technologie ingenieurgemäß realisieren, Steuersignale z. B. durch negierte Steuersignale ersetzten, etwa die Ausgänge Data-out 7 und Scan-out 8 jeweils in einem zusätzlichen Latch, das beispielsweise mit einem nicht-überlappenden Taktsignal getaktet ist insbesondere dann zwischenspeichern, wenn die Speicherelemente zur Speicherung von einem Bit als Latches realisiert sind und etwa im Falle der Zwischenspeicherung der Ausgänge Data-out 7 und Scan-out 8 in jeweils einem Latch diese Latches in die Schaltungsoptimierung einbeziehen, wie das beim Entwurf von Schaltungen durch einen ausgebildeten Entwerfer üblich ist.

## Patentansprüche

1. Multi-Mode Speicherelement für sequentielle Schaltungsanordnungen mit Scan-Mode oder partiellem Scan-Mode und pseudo-zufälligem Selbsttest, welches einen Data-in Eingang (1), einen Data-out Ausgang (7), einen Scan-in Eingang (2) und einen Scan-out Ausgang (8) aufweist, wobei der Data-in Eingang (1) mit dem Daten-Eingang eines ersten Speicherelements (3) zur Speicherung von einem Bit verbunden ist, und welches einen Multiplexer (5) aufweist, **dadurch gekennzeichnet, daß** der Scan-in Eingang (2) mit dem Daten-Eingang eines zweiten Speicherelements (4) zur Speicherung von einem Bit verbunden ist, der Ausgang des ersten Speicherelements (3) zur Speicherung von einem Bit mit dem ersten von zwei Eingängen des Multiplexers (5) verbunden ist, dessen Steuerleitung (9) ein erstes binäres Steuersignal führt, der Ausgang des ersten Speicherelements (3) zur Speicherung von einem Bit gleichzeitig mit dem ersten von zwei Eingängen einer gesteuerten Verknüpfungsschaltung (6) verbunden ist, deren Steuerleitung (10) ein zweites binäres Steuersignal führt, der Ausgang des zweiten Speicherelements (4) zur Speicherung von einem Bit mit dem zweiten Eingang des Multiplexers (5) und mit dem zweiten Eingang der gesteuerten Verknüpfungsschaltung (6) verbunden ist, der Ausgang des Multiplexers (5) mit dem Data-out Ausgang (7) verbunden ist, und der Ausgang der gesteuerten Verknüpfungsschaltung (6) mit dem Scan-out Ausgang (8) verbunden ist, und die gesteuerte Verknüpfungsschaltung (6) für den ersten Zustand ihres binären Steuersignals eine Verknüpfung ihrer beiden Eingänge mit einer eindeutig auflösbaren Booleschen Funktion realisiert und für den zweiten Zustand ihres binären Steuersignals ein am zweiten Eingang anliegendes Signal unverändert an ihren Scan-out Ausgang (8) weiterleitet.

2. Multi-Mode Speicherelement für sequentielle Schaltungsanordnungen mit Scan-Mode oder partiellem Scan-Mode und pseudo-zufälligem Selbsttest, welches einen Data-in Eingang (1), einen Data-out Ausgang (7), einen Scan-in Eingang (2) und einen Scan-out Ausgang (8) aufweist, wobei der Data-in Eingang (1) mit dem Daten-Eingang eines ersten Speicherelements (3) zur Speicherung von einem Bit verbunden ist, und welches einen Multiplexer (5) aufweist, **dadurch gekennzeichnet, daß** der Scan-in Eingang (2) mit dem Daten-Eingang eines zweiten Speicherelements (4) zur Speicherung von einem Bit verbunden ist, der Ausgang des ersten Speicherelements (3) zur Speicherung von einem Bit mit dem ersten von zwei Eingängen des Multiplexers (5) verbunden ist, dessen Steuerleitung ein binäres Steuersignal führt, der Ausgang des ersten Speicherelements (3) zur Speicherung von einem Bit gleichzeitig mit dem ersten von zwei Eingängen einer gesteuerten Verknüpfungsschaltung (6) verbunden ist, deren Steuerleitung mit der Steuerleitung des Multiplexers (5) zu einer Steuerleitung (11) verbunden ist und das binäre Steuersignal führt, der Ausgang des zweiten Speicherelements (4) zur Speicherung von einem Bit mit dem zweiten Eingang des Multiplexers (5) und mit dem zweiten Eingang der gesteuerten Verknüpfungsschaltung (6) verbunden ist, der Ausgang des Multiplexers (5) mit dem Data-out Ausgang (7) verbunden ist, und der Ausgang der gesteuerten Verknüpfungsschaltung (6) mit dem Scan-out Ausgang (8) verbunden ist, und die gesteuerte Verknüpfungsschaltung (6) für den ersten Zustand des binären Steuersignals eine Verknüpfung ihrer beiden Eingänge mit einer eindeutig auflösbaren Booleschen Funktion realisiert und für den zweiten Zustand des binären Steuersignals ein am zweiten Eingang anliegendes Signal unverändert an ihren Scan-out Ausgang (8) weiterleitet.

3. Multi-Mode Speicherelement nach Anspruch 2, **dadurch gekennzeichnet, daß** die Steuerleitung des Multiplexers (5) und die Steuerleitung der Verknüpfungsschaltung (6) so zu einer Steuerleitung (11) verbunden sind, daß bei deren einem Steuersignalzustand der an einen entsprechenden Ausgang einer zu testenden kombinatorischen Schaltung (20) angeschlossene Data-in Eingang (1) über das erste Speicherelement (3) zur Speicherung von einem Bit und den Multiplexer (5) an den Data-out Ausgang (7), der mit einem entsprechenden Eingang der zu testenden kombinatorischen Schaltung (20) verbunden ist, geführt ist, und der Scan-in Eingang (2) über das zweite Speicherelement (4) zur Speicherung von einem Bit und die Verknüpfungsschaltung (6) logisch unverknüpft an den Scan-out Ausgang (8) geführt ist, der mit dem Scan-in Eingang (2) eines nächsten Multi-Mode Speicherelements verbunden ist, und daß beim anderen Steuersignalzustand der Steuerleitung (11) das Signal vom Scan-in Eingang (2) über das zweite Speicherelement (4) zur Speicherung eines Bits und den Multiplexer (5) an den Data-out Ausgang (7) geführt ist und das Signal vom Data-in Eingang (1) über das erste Speicherelement (3) zur Speicherung von einem Bit und das Signal vom Scan-in Eingang (2) über das zweite Speicherelement (4) zur Speicherung von einem Bit gemeinsam über die Verknüpfungsschaltung (6), verknüpft mit einer eindeutig auflösbaren Booleschen Funktion, an den Scan-out Ausgang (8) geführt sind.

4. Multi-Mode Speicherelement nach Anspruch 1, 2 oder 3, **dadurch gekennzeichnet, daß** die Verknüpfungsschaltung (6) eine Äquivalenzverknüpfung realisiert.

5. Multi-Mode Speicherelement nach Anspruch 1, 2 oder 3, **dadurch gekennzeichnet, daß** die Verknüpfungsschaltung (6) eine Antivalenzverknüpfung realisiert.

6. Multi-Mode Speicherelement nach Anspruch 1, 2, 3, 4, oder 5, **dadurch gekennzeichnet, daß** die Speicherelemente (3, 4) zur Speicherung von einem Bit Flip-Flops sind.

7. Multi-Mode Speicherelement nach Anspruch 1, 2, 3, 4, oder 5, **dadurch gekennzeichnet, daß** die Speicherelemente (3, 4) zur Speicherung von einem Bit Latches sind.

8. Multi-Mode Speicherelement nach Anspruch 7, **dadurch gekennzeichnet, daß** die Signale der Ausgänge Data-out (7) und Scan-out (8) jeweils in einem zusätzlichen Latch speicherbar sind.

9. Multi-Mode Speicherelement nach Anspruch 8 , **dadurch gekennzeichnet, daß** die Latches, in denen die Signale der Ausgänge Data-out (7) und Scan-out (8) speicherbar sind, mit Taktsignalen taktbar sind, die nichtüberlappend zu den Taktsignalen sind, mit denen die Latches taktbar sind, die die Speicherelemente (3, 4) zur Speicherung von einem Bit realisieren.

## Claims

1. Multi-mode storage element for sequential circuit arrangements having scan mode or partial scan-mode and pseudo-random self-test, which comprises a Data-in input (1), a Data-out output (7), a Scan-in input (2) and a Scan-out output (8), where the Data-in input (1) is connected to the data input of a first storage element (3) for storing one bit, and which comprises a multiplexer (5), **characterized in that** the Scan-in input (2) is connected to the data input of a second storage element (4) for storing one bit, the output of the first storage element (3) for storing one bit is connected to the first of two inputs of the multiplexer (5), whose control line (9) carries a first binary control signal, the output of the first storage element (3) for storing one bit is also connected to the first of two inputs of a controlled combinational logic circuit (6), whose control line (10) carries a second binary control signal, the output of the second storage element (4) for storing one bit is connected to the second input of the multiplexer (5) and to the second input of the controlled combinational logic circuit (6), the output of the multiplexer (5) is connected to the Data-out output (7), and the output of the controlled combinational logic circuit (6) is connected to the Scan-out output (8), and the controlled combinational logic circuit (6), for the first state of its binary control signal, implements a logical operation of its two inputs by a uniquely solvable Boolean function, and for the second state of its binary control signal, passes a signal applied to the second input unchanged to its Scan-out output (8).

2. Multi-mode storage element for sequential circuit arrangements having scan mode or partial scan-mode and pseudo-random self-test, which comprises a Data-in input (1), a Data-out output (7), a Scan-in input (2) and a Scan-out output (8), where the Data-in input (1) is connected to the data input of a first storage element (3) for storing one bit, and which comprises a multiplexer (5), **characterized in that** the Scan-in input (2) is connected to the data input of a second storage element (4) for storing one bit, the output of the first storage element (3) for storing one bit is connected to the first of two inputs of the multiplexer (5), whose control line carries a binary control signal, the output of the first storage element (3) for storing one bit is also connected to the first of two inputs of a controlled combinational logic circuit (6), whose control line is connected to the control line of the multiplexer (5) into a control line (11) and carries the binary control signal, the output of the second storage element (4) for storing one bit is connected to the second input of the multiplexer (5) and to the second input of the controlled combinational logic circuit (6), the output of the multiplexer (5) is connected to the Data-out output (7), and the output of the controlled combinational logic circuit (6) is connected to the Scan-out output (8), and the controlled combinational logic circuit (6), for the first state of the binary control signal, implements a logical operation of its two inputs by a uniquely solvable Boolean function, and for the second state of the binary control signal, passes a signal applied to the second input unchanged to its Scan-out output (8).

3. Multi-mode storage element according to Claim 2, **characterized in that** the control line of the multiplexer (5) and the control line of the combinational logic circuit (6) are connected into one control line (11), such that for one control signal state of the control line, the Data-in input (1) connected to a corresponding output of a combinational logic circuit (20) to be tested is taken via the first storage element (3) for storing one bit and the multiplexer (5) to the Data-out output (7), which is connected to a corresponding input of the combinational logic circuit (20) to be tested, and the Scan-in input (2) is taken via the second storage element (4) for storing one bit and the combinational logic circuit (6) without undergoing a logical operation to the Scan-out output (8), which is connected to the Scan-in input (2) of a subsequent multi-mode storage element, and such that for the other control signal state of the control line (11), the signal from the Scan-in input (2) is taken via the second storage element (4) for storing one bit and the multiplexer (5) to the Data-out output (7), and the signal from the Data-in input (1) and the signal from the Scan-in input (2) are taken respectively via the first storage element (3) for storing one bit and via the second storage element (4) for storing one bit, and jointly via the combinational logic circuit (6) to the Scan-out output (8), undergoing a logical operation by a uniquely solvable Boolean function.

4. Multi-mode storage element according to Claim 1, 2 or 3, **characterized in that** the combinational logic circuit (6) implements an inverse exclusive-OR logic operation.

5. Multi-mode storage element according to Claim 1, 2 or 3, **characterized in that** the combinational logic circuit (6) implements an exclusive-OR logic operation.

6. Multi-mode storage element according to Claim 1, 2, 3, 4 or 5, **characterized in that** the storage elements (3, 4) for storing one bit are flip-flops.

7. Multi-mode storage element according to Claim 1, 2, 3, 4 or 5, **characterized in that** the storage elements (3, 4) for storing one bit are latches.

8. Multi-mode storage element according to Claim 7, **characterized in that** the signals from the outputs Data-out (7) and Scan-out (8) can each be stored in an additional latch.

9. Multi-mode storage element according to Claim 8, **characterized in that** the latches in which the signals from the outputs Data-out (7) and Scan-out (8) can be stored, can be clocked by clock signals that do not overlap the clock signals that can be used to clock the latches that implement the storage elements (3, 4) for storing one bit.

## Revendications

1. Elément mémoire multi-mode pour des circuits séquentiels avec mode Scan ou mode Scan partiel et auto-test pseudo-aléatoire, comprenant une entrée Data-in (1), une sortie Data-out (7), une entrée Scan-in (2) et une sortie Scan-out (8), l'entrée Data-in (1) étant reliée avec l'entrée de données d'un premier élément mémoire (3) pour la mémorisation d'un bit et comprenant un multiplexeur (5),
**caractérisé en ce que**
l'entrée Scan-in (2) est reliée avec l'entrée de données d'un deuxième élément mémoire (4) pour la mémorisation d'un bit, la sortie du premier élément mémoire (3) pour la mémorisation d'un bit est reliée avec la première des deux entrées du multiplexeur (5) dont la ligne de commande (9) conduit un premier signal de commande binaire,
la sortie du premier élément mémoire (3) pour la mémorisation d'un bit est reliée simultanément avec la première des deux entrées d'un circuit combinatoire commandé (6), dont la ligne de commande (10) conduit un deuxième signal de commande binaire,
la sortie du deuxième élément mémoire (4) pour la mémorisation d'un bit est reliée avec la deuxième entrée du multiplexeur (5) et avec la deuxième entrée du circuit combinatoire (6) commandé,
la sortie du multiplexeur (5) est reliée avec la sortie Data-out (7) et
la sortie du circuit combinatoire (6) commandé est reliée avec la sortie Scan-out (8) et
le circuit combinatoire (6) commandé réalise, pour le premier état de son signal de commande binaire, une combinaison de ses deux entrées avec une fonction booléenne résoluble univoquement et envoie, de façon inchangée, à sa sortie Scan-out (8) un signal appliqué à la deuxième entrée, pour le deuxième état de son signal de commande binaire.

2. Elément mémoire multi-mode pour des circuits séquentiels avec mode Scan ou mode Scan partiel et auto-test pseudo-aléatoire, comprenant une entrée Data-in (1), une sortie Data-out (7), une entrée Scan-in (2) et une sortie Scan-out (8), l'entrée Data-in (1) étant reliée avec l'entrée de données d'un premier élément mémoire (3) pour la mémorisation d'un bit et comprenant un multiplexeur (5),
**caractérisé en ce que**
l'entrée Scan-in (2) est reliée avec l'entrée de données d'un deuxième élément mémoire (4) pour la mémorisation d'un bit, la sortie du premier élément mémoire (3) pour la mémorisation d'un bit est reliée avec la première des deux entrées du multiplexeur (5) dont la ligne de commande conduit un signal de commande binaire,
la sortie du premier élément mémoire (3) pour la mémorisation d'un bit est reliée simultanément avec la première des deux entrées d'un circuit combinatoire commandé (6), dont la ligne de commande est reliée avec la ligne de commande du multiplexeur (5) pour obtenir une ligne de commande (11) et conduit le signal de commande binaire,
la sortie du deuxième élément mémoire (4) pour la mémorisation d'un bit est reliée avec la deuxième entrée du multiplexeur (5) et avec la deuxième entrée du circuit combinatoire (6) commandé,
la sortie du multiplexeur (5) est reliée avec la sortie Data-out (7) et
la sortie du circuit combinatoire (6) commandé est reliée avec la sortie Scan-out (8) et
le circuit combinatoire (6) commandé réalise, pour le premier état de son signal de commande binaire, une combinaison de ses deux entrées avec une fonction booléenne résoluble univoquement et envoie, de façon inchangée, à sa sortie
Scan-out (8) un signal appliqué à la deuxième entrée, pour le deuxième état de son signal de commande binaire.

3. Elément mémoire multi-mode selon la revendication 2, **caractérisé en ce que** la ligne de commande du multiplexeur (5) et la ligne de commande du circuit combinatoire (6) sont reliées pour obtenir une ligne de commande (11) de telle façon que pour un état de signal de commande de celle-ci, l'entrée Data-in (1) connectée à une sortie correspondante d'un circuit combinatoire (20) à tester est conduite, via le premier élément mémoire (3) pour la mémorisation d'un bit et le multiplexeur (5), à la sortie Data-out (7), qui est reliée avec une entrée correspondante du circuit (20) combinatoire à tester, et
l'entrée Scan-in (2) est conduite de façon logique non combinée, via le deuxième élément mémoire (4) pour la mémorisation d'un bit et le circuit combinatoire (6), à la sortie Scan-out (8) qui est reliée avec l'entrée Scan-in (2) d'un élément mémoire multi-mode suivant et que
lors de l'autre état de signal de commande de la ligne de commande (11), le signal de l'entrée Scan-in (2) est envoyé, via le deuxième élément mémoire (4) pour la mémorisation d'un bit et le multiplexeur (5), à la sortie (7) Data-out et
le signal de l'entrée Data-in (1), via le premier élément mémoire (3) pour la mémorisation d'un bit, et le signal de l'entrée Scan-in (2), via le deuxième élément mémoire (4) pour la mémorisation d'un bit, sont envoyés ensemble, via le circuit combinatoire (6), à la sortie Scan-out (8) de façon combinée avec une fonction booléenne résoluble univoquement.

4. Elément mémoire multi-mode selon la revendication 1, 2, ou 3, **caractérisé en ce que** le circuit combinatoire (6) réalise une fonction logique d'équivalence.

5. Elément mémoire multi-mode selon la revendication 1, 2, ou 3, **caractérisé en ce que** le circuit combinatoire (6) réalise une fonction logique OU-exclusif.

6. Elément mémoire multi-mode selon la revendication 1, 2, 3, 4 ou 5 **caractérisé en ce que** les éléments mémoire (3, 4) pour la mémorisation d'un bit sont des flip-flops.

7. Elément mémoire multi-mode selon la revendication 1, 2, 3, 4 ou 5 **caractérisé en ce que** les éléments mémoire (3, 4) pour la mémorisation d'un bit sont des latches.

8. Elément mémoire multi-mode selon la revendication 7 **caractérisé en ce que** les signaux des sorties Data-out (7) et Scan-out (8) sont à chaque fois mémorisables dans une latch supplémentaire.

9. Elément mémoire multi-mode selon la revendication 8 **caractérisé en ce que** les latches, dans lesquelles les signaux des sorties Data-out (7) et Scan-out (8) sont mémorisables, peuvent être cadencées avec des signaux d'horloge qui ne chevauchent pas les signaux d'horloge avec lesquels les latches qui réalisent les éléments mémoire (3, 4) pour la mémorisation d'un bit, peuvent être cadencées.
